# EUROPÄISCHE PATENTSCHRIFT

(11) **EP 1 149 300 B1**
(45) Veröffentlichungstag und Bekanntmachung des Hinweises auf die Patenterteilung: **09.04.2003**
(21) Anmeldenummer: 00907449.3
(22) Anmeldetag: 26.01.2000
(51) Int. Cl.: G01R 33/02

(54) **VORRICHTUNG UND VERFAHREN ZUR BESTIMMUNG EINES MAGNETFELDES**
DEVICE AND METHOD FOR DETERMINING A MAGNETIC FIELD
DISPOSITIF ET PROCEDE POUR DETERMINER UN CHAMP MAGNETIQUE

(30) Priorität: 28.01.1999 DE 19903296
(43) Veröffentlichungstag der Anmeldung: 31.10.2001
(73) Patentinhaber: ROBERT BOSCH GMBH, 70442 Stuttgart (DE)
(72) Erfinder: MARX, Klaus, D-70565 Stuttgart (DE); KITTEL, Hartmut, D-71287 Weissach-Flacht (DE)
(86) Internationale Anmeldenummer: DE0000211
(87) Internationale Veröffentlichungsnummer: WO00045190

(56) Entgegenhaltungen:
- DE-A- 19 543 562
- US-A- 4 866 384
- US-A- 5 103 174
- US-A- 5 859 754

## Beschreibung

### Stand der Technik

Die Erfindung betrifft eine Vorrichtung und ein Verfahren zur Bestimmung eines Magnetfeldes, insbesondere hinsichtlich dessen Stärke und Richtung in unmittelbarer Nähe der Oberfläche eines Magneten, nach der Gattung der unabhängigen Ansprüche.

Die Messung von orthogonal zu Magnetoberflächen austretenden Magnetfeldern oder Magnetfeldkomponenten kann bekanntermaßen sehr genau mit Hilfe von Hallsonden oder Feldplatten als Sensoren gemessen werden, da diese empfindlich auf Magnetfeldkomponenten senkrecht zur Sensoroberfläche sind. Die parallel zu Magnetoberflächen verlaufenden Magnetfeldkomponenten lassen sich mit diesen Sensoren routinemäßig jedoch nur in relativ großen Abständen von in der Regel einigen Millimetern messen, da sie dazu senkrecht auf die Oberfläche des Magneten gestellt werden müssen.

Aus dem Stand der Technik bekannte Meßmethoden und Meßsensoren auf Basis des Halleffektes sind beispielsweise in dem Aufsatz "Neue alternative Lösungen für Drehzahlsensoren im Kraftfahrzeug auf magnetoresistiver Basis" aus dem VDI-Bericht Nr. 509, 1984, VDI-Verlag, beschrieben. Weiterhin sind auch bereits Hallsensoren zur Erfassung von tangential zur Magnetoberfläche gerichteten Feldern aus "Sensors and Materials", 5, 2 (1992), S. 91 bis 101, MYU, Tokio, und insbesondere dem darin enthaltenen Aufsatz von M. Parajape, L.

Ristic und W Allegretto, "Simulation, Design and Fabrication of a Vertical Hall Device for Two-Dimensional Magnetic Field Sensing", bekannt.

Neben den auf dem Hall-Effekt basierenden Sensoren sind weiterhin auch sogenannte AMR- und GMR-Winkelsensoren bekannt, die auf dem sogenannten magnetoresistiven Effekt beruhen (GMR = giant magneto resistance, AMR = anisotropic magneto resistance) und mit denen in einfacher Weise eine parallel zur Sensoroberfläche gerichtete Komponente eines Magnetfeldes gemessen werden kann.

Derartige Sensoren, die beispielsweise in DE 195 43 562 A1 und in DE 44 08 078 beschrieben werden, sind jedoch innerhalb ihres Arbeitsbereiches im wesentlichen nur hinsichtlich der Richtung des zu messenden Magnetfeldes empfindlich und nur schwach hinsichtlich dessen Stärke. Dabei ist gleichzeitig die Temperaturabhängigkeit der gemessenen Amplitude eines derartigen Sensors groß, was zu erheblichen Meßfehlern führen kann. Andererseits beträgt bei bekannten AMR- oder GMR-Winkelsensoren die Winkelgenauigkeit d.h. die Meßgenauigkeit zur Bestimmung der Richtung eines äußeren bzw. vom Sensor auszumessenden Magnetfeldes ca. 0,5°, wobei diese Winkelmessung, im Gegensatz zur Stärkenmessung, lediglich in vernachläßigbarer Weise temperaturabhängig ist.

Gleichzeitig haben diese Sensoren aber den Vorteil, daß sie beispielsweise auch in unmittelbarer Nähe der Oberfläche eines das auszumessende Magnetfeld erzeugenden Magneten, d.h. in einem typischen Abstand von weniger als 1 mm, einsetzbar sind. Dazu sei erneut auf den Aufsatz "Neue alternative Lösungen für Drehzahlsensoren im Kraftfahrzeug auf magnetoresistiver Basis" aus dem VDI-Bericht Nr. 509, 1984, VDI-Verlag, verwiesen.

Die Funktion von AMR- und GMR-Winkelsensoren und ihre Verwendung zur Messung von Magnetfeldern wird darüberhinaus im Detail auch in Sensors and Actuators A21-A23, "A Thin Film Magnetoresistive Angle Detector", 1990, S. 795 bis 798, beschrieben.

Aus US 4,66,384 ist eine Anzeigevorrichtung zur Ermittlung der Richtung eines Magnetfeldes, bekannt, die wie ein Kompass arbeitet. Die Stärke des Magnetfeldes ist mit dieser Vorrichtung nicht ermittelbar. In US 5,859,754 wird die Verwendung von AMR- und GMR-Sensoren beschrieben, um Änderungen des magnetischen Flusses in einem Lesekopf zu erfassen. In US 5,103,174 werden schließlich mit Hilfe einer feinen Spitze, die über den Piezoeffekt bewegbar ist, auf der Grundlage des Tunnel-Effektes kleinste Änderungen eines Prüfmaterials als Funktion der Umweltbedingungen, beispielsweise hinsichtlich Temperatur, Druck oder magnetischen und elektrischen Feldern, detektiert.

### Vorteile der Eründung

Die erfindungsgemäße Vorrichtung und das damit durchgeführte Verfahren zur Bestimmung eines Magnetfeldes mit den kennzeichnenden Merkmalen der unabhängigen Ansprüche hat gegenüber dem Stand der Technik den Vorteil, daß damit ermöglicht wird, weitgehend beliebige Magnetfelder an einem gewählten Detektionsort hinsichtlich deren Stärke und Richtung zu bestimmen. Besonders vorteilhaft ist dabei, daß damit auch Magnetfelder oder Magnetfeldkomponenten, die parallel zu der Oberfläche beispielsweise eines diese Magnetfeldkomponenten erzeugenden Magneten gerichtet sind bzw. aus diesem austreten, bis dicht an die Oberfläche dieses Magneten gemessen werden können.

Vorteilhafte Weiterbildungen der Erfindung ergeben sich aus den in den Unteransprüchen genannten Maßnahmen.

So wird als für die Messung des interessierenden bzw. zu bestimmenden Magnetfeldes benötigtes Hilfsmagnetfeld sehr vorteilhaft ein zunächst beliebig erzeugtes Hilfsmagnetfeld eingesetzt werden, das jedoch zumindest hinsichtlich seiner Stärke, vorzugsweise hinsichtlich seiner Stärke und Richtung bekannt sein muß. Zur Erzeugung dieses Hilfsmagnetfeldes eignet sich vorteilhaft ein Helmholtz-Spulenpaar, in dessen Zentrum bekanntermaßen ein homogenes, hinsichtlich Stärke und Richtung bekanntes und beispielsweise über den Spulenstrom in einfacher Weise definiert einstellbares Magnetfeld vorliegt.

Zur Detektion des aus der Überlagerung des Hilfsmagnetfeldes und des zu messenden Magnetfeldes resultierenden Magnetfeldes hinsichtlich dessen Richtung wird besonders vorteilhaft ein an sich bekannter und kommerziell erhältlicher AMR-Winkelsensor oder GMR-Winkelsensor verwendet.

Dabei ist es sehr vorteilhaft, wenn in den AMR- oder GMR-Winkelsensor gleichzeitig auch eine Vorrichtung, wie beispielsweise eine Spule mit einem damit erzeugbaren, definierten und variierbaren Magnetfeld, zur Erzeugung des Hilfsmagnetfeldes integriert ist, so daß ein externes Bauteil, wie das genannte Helmholtz-Spulenpaar, entfallen kann.

Überdies kann der verwendete GMR- oder AMR-Winkelsensor vor Beginn der Messung des interessierenden Magnetfeldes, das beispielsweise aus der Oberfläche eines Magneten austritt, sehr vorteilhaft zu Eich- oder Testmessungen herangezogen werden, indem zunächst in Abwesenheit dieses Magneten mit dem GMR- oder AMR-Winkelsensor das erzeugte Hilfsmagnetfeld am jeweiligen Detektionsort hinsichtlich Stärke oder hinsichtlich Stärke und Richtung für verschiedene Parametereinstellungen zur Erzeugung des Hilfsmagnetfeldes ausgemessen oder geeicht wird. Alternativ kann zur Messung des Hilfsmagnetfeldes jedoch vorteilhaft auch ein Hall-Sensor verwendet werden. Das Hilfsmagnetfeld ist somit bei der nachfolgenden Messung des zu bestimmenden Magnetfeldes, bei der dann beispielsweise der das zu bestimmende Magnetfeld erzeugende Magnet am betreffenden Detektionsort plaziert ist, für die verschiedenen Parametereinstellungen des Hilfsmagnetfeldes (beispielsweise des Spulenstroms) jeweils bekannt.

Die Bestimmung des interessierenden Magnetfeldes erfolgt in einfacher und vorteilhafter Weise dadurch, daß aus der am Detektionsort gemessenen Richtung des aus der Überlagerung von Hilfsmagnetfeld und zu messendem Magnetfeld erzeugten resultierenden Magnetfeldes, das zu messende Magnetfeld unter Verwendung des bekannten Hilfsmagnetfeldes errechnet wird.

Dazu wird die Richtung des resultierenden Magnetfeldes für mindestens zwei, hinsichtlich ihrer verschiedenen Hilfsmagnetfelder am Detektionsort bestimmt und unter Verwendung einer an sich bekannten numerischen Anpassung, die vorzugsweise mit Hilfe eines Computerprogrammes durchgeführt wird, daraus das zu messende Magnetfeld hinsichtlich dessen Stärke und Richtung errechnet. Diese numerische Anpassung erfolgt zur Verbesserung der numerischen Stabilität und der Meßgenauigkeit sehr vorteilhaft unter Verwendung von Meßdaten aus einer Vielzahl von Bestimmungen des resultierenden Magnetfeldes bei jeweils verschiedenen Hilfsfeldern. Weiterhin ist es für die Meßgenauigkeit und aus numerischen Gründen sehr vorteilhaft, wenn die Hilfsmagnetfelder jeweils grob senkrecht zur vermutlichen Richtung des zu messenden Magnetfeldes ausgerichtet sind.

Das erfindungsgemäße Verfahren eignet sich besonders vorteilhaft zur Bestimmung eines aus einer Oberfläche eines Magneten austretenden Magnetfeldes sowie insbesondere zur Bestimmung eines weitgehend parallel zur Oberfläche eines Magneten gerichteten Magnetfeldes in unmittelbarer Nähe der Oberfläche dieses Magneten. Es kann routinemäßig beispielsweise in der Qualitätsprüfung von Magneten eingesetzt werden.

### Zeichnung

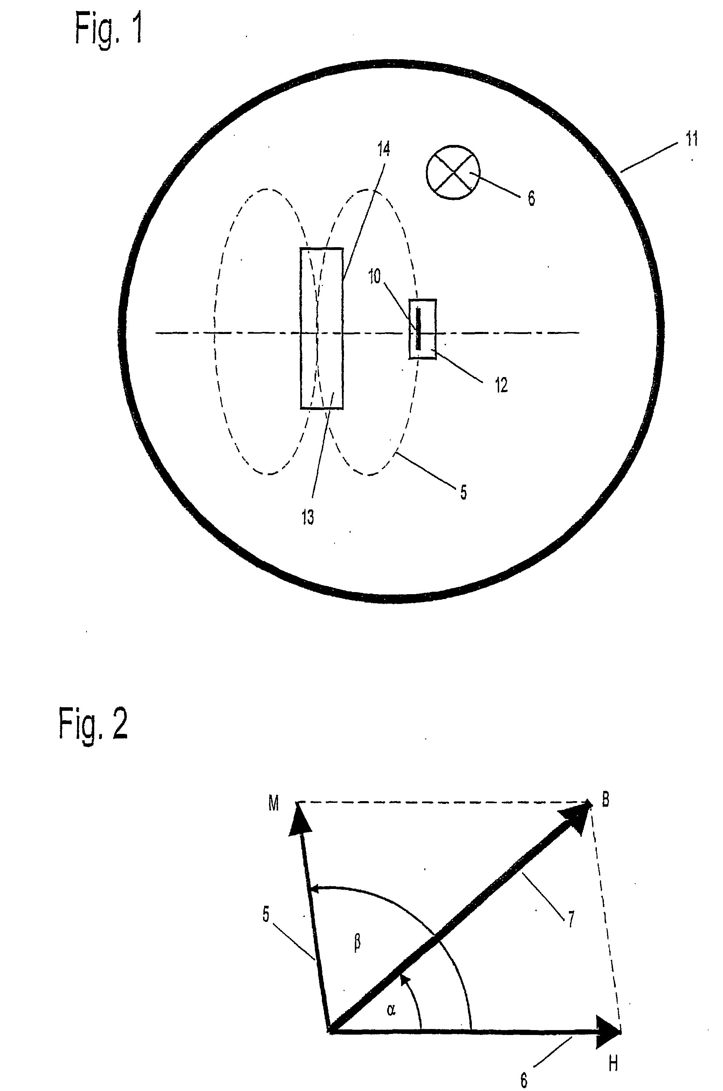

Ausführungsbeispiele der Erfindung werden anhand der Zeichnung und in der nachfolgenden Beschreibung näher erläutert. Die Figur 1 zeigt schematisch eine Vorrichtung zur Messung eines Magnetfeldes und die Figur 2 erläutert die Bezeichnungen und Richtungen der verschiedenen auftretenden Magnetfelder.

### Ausführungsbeispiele

Die Figur 1 zeigt einen Magneten 13 mit einer Oberfläche 14 aus dem ein zu messendes Magnetfeld 5 (in Fig. 1 lediglich schematisch angedeutet) austritt, das insbesondere auch parallel zu der Oberfläche 14 verlaufende Magnetfeldkomponenten aufweist. Weiterhin ist ein Helmholtz-Spulenpaar 11 vorgesehen, das ein Hilfsmagnetfeld 6 (in Fig. 1 lediglich schematisch angedeutet durch dessen Richtung) erzeugt, dessen Stärke über äußere Parameter, wie beispielsweise einen Spulenstrom, einstellbar ist. Der Magnet 13 ist grob im Zentrum zwischen dem Helmholtz-Spulenpaar 11 angeordnet. Weiterhin ist ein an sich bekannter, kommerziell erhältlicher AMR-Winkelsensor 12 vorgesehen. Im konkreten Fall handelt es sich um den Winkelsensor KMZ41 der Firma Philips Semiconductors, Hamburg. Anstelle des AMR-Winkelsensors kann jedoch auch ein ebenfalls an sich bekannter, kommerziell erhältlicher GMR-Winkelsensor eingesetzt werden.

Der AMR-Winkelsensor 12 befindet sich am Detektionsort 10, der wiederum in unmittelbarer Nähe der Oberfläche 14 des Magneten 13 liegt. Der Abstand von Detektionsort 10 und Oberfläche 14 beträgt insbesondere 0,3 mm bis 3 mm. Die untere Abstandsgrenze ist dabei nur durch die Dicke des Gehäuses des AMR-Winkelsensors 12 begrenzt.

Es sei an dieser Stelle darauf hingewiesen, daß die Figur 1 nicht maßstäblich zu verstehen ist, da der Durchmesser des Helmholtz-Spulenpaares 11 wesentlich größer ist, als der Abstand der Oberfläche 14 vom Detektionsort 10. Damit sind insbesondere Unterschiede des Hilfsmagnetfeldes 6 hinsichtlich dessen Stärke und Richtung zwischen dem Detektionsort 10 und der Oberfläche 14 vernachlässigbar.

Die Figur 2 erläutert die Richtungen der auftretenden Magnetfelder, die als Vektoren dargestellt sind und jeweils durch ihren Betrag bzw. Stärke und ihre Richtung gekennzeichnet sind. Zunächst wird über das Helmholtz-Spulenpaar 11 das Hilfsmagnetfeld 6 erzeugt, das auch mit H bezeichnet ist. Aus dem Magneten 13 tritt das zu messende Magnetfeld 5 aus, das auch mit M bezeichnet ist. Das Hilfsmagnetfeld 6 ist dabei uber die Anordnung der Helmholtz-Spulenpaares 11 bevorzugt zunächst grob so orientiert, daß seine Richtung etwa senkrecht auf der vermuteten Richtung des zu messenden Magnetfeldes 5 steht. Aus der Überlagerung des zu messenden Magnetfeldes 5 und des Hilfsmagnetfeldes 6 entsteht am Detektionsort 10 ein resultierendes Magnetfeld 7, das gegenüber dem zu messenden Magnetfeld 5 und dem Hilfsmagnetfeld 6 gedreht ist und das auch mit B bezeichnet ist. Der Winkel zwischen der Richtung des Hilfsmagnetfeldes 6 und des resultierenden Magnetfeldes 7 wird mit α bezeichnet. Die zunächst unbekannte Richtung des zu messenden Magnetfeldes 5 wird mit dem Winkel β bezeichnet, der ebenfalls auf die Richtung des Hilfsmagnetfeldes 6 bezogen wird.

Zur Bestimmung des Magnetfeldes 5 ist zunächst zu gewährleisten, daß das Hilfsmagnetfeld 6 zumindest hinsichtlich seiner Stärke, bevorzugt jedoch hinsichtlich seiner Stärke und Richtung am Detektionsort 10 bekannt ist. Dies erfolgt beispielsweise über ein Ausmessen oder ein Eichen des Magnetfeldes des Helmholtz-Spulenpaares 11 vor dem Einbringen des Magneten 13 in deren Feld unter Verwendung einer Hall-Sonde und/oder eines an sich bekannten GMR- oder eines AMR-Winkelsensors. Das konkrete verwendete Verfahren zur Bestimmung oder Eichung des Hilfsmagnetfeldes 6 bei diesen Testoder Eichmessungen ist jedoch völlig beliebig. Weiterhin muß die Stärke des Hilfsmagnetfeldes 6, beispielsweise durch eine Einstellung eines äußeren Parameters, wie eines das Hilfsmagnetfeld 6 erzeugenden Spulenstroms, in definierter Weise variierbar sein.

Kern des Meßverfahrens ist nun die Tatsache, daß durch das definierte Überlagern des Hilfsmagnetfeldes 6 am Detektionsort 10 die Richtung des resultierenden Magnetfeldes 7 gegenüber der Richtung des zu messenden Magnetfeldes 5 und der Richtung des Hilfsmagnetfeldes 6 gedreht wird. Diese Drehung ist von der Stärke des Hilfsmagnetfeldes 6 aber auch von der Stärke des zu messenden Magnetfeldes 5 abhängig. Aus der Kenntnis der Stärke oder der Stärke und der Richtung des Hilfsmagnetfeldes 6 sowie der Messung des Drehwinkels α kann man dann die Stärke und die Richtung des zu messenden Feldes 5 berechnen.

Dabei gilt folgender Zusammenhang aus der Vektorsummation der einzelnen Magnetfelder:

*M* cos(β)tan(α) *+ H* tan(α) *- M* sin(β) = 0 (1)

wobei β als zunächst unbekannter Winkel die Richtung des zu messenden Magnetfeldes 5 angibt, das eine zunächst ebenfalls unbekannte Stärke M hat.

Bekannt in Gleichung (1) ist die Stärke H des Hilfsmagnetfeldes 6, die, wie beschrieben, beispielsweise vorab über eine Messung mittels einer Hall-Sonde ermittelt wurde. Über den AMR-Winkelsensor 12 ist weiterhin der Winkel α, also die Richtung des resultierenden Magnetfeldes 7 bezüglich der Richtung des Hilfsmagnetfeldes 6 meßbar. Dies geschieht beispielsweise in bekannter Weise über die in DE 195 43 562.1 A1 beschriebene Sinus-Cosinus-Auswertung. Zur Vereinfachung des weiteren Vorgehens ist es dabei sehr vorteilhaft, wenn neben der Stärke auch die Richtung des Hilfsmagnetfeldes 6 bekannt ist, da der Winkel α auf diese Richtung bezogen wird.

Insgesamt enthält die Gleichung 1 somit bei bekanntem Hilfsmagnetfeld zwei Unbekannte, nämlich β und M. Prinzipiell genügen damit zwei Messungen mit zwei verschiedenen, d.h. unterschiedlich starken Hilfsmagnetfeldern 6, um diese Unbekannten zu errechnen.

Sofern die Richtung des Hilfsmagnetfeldes 6 in besonderen Fällen zusätzlich ebenfalls unbekannt sein sollte, enthält die Gleichung 1 weiterhin noch eine dritte Unbekannte. In diesem Fall sind demnach mindestens drei Messungen mit unterschiedlich starken, in ihrer Richtung aber jeweils konstanten Hilfsmagnetfeldern 6 erforderlich, da der von dem AMR-Winkelsensor 12 gemessene Winkel des resultierenden Magnetfeldes 7 dann auf die unbekannte, aber konstante Richtung des Hilfsmagnetfeldes 6 bzw. den dadurch definierten Referenzwinkel bezogen werden muß. Diese zusätzliche Komplikation macht die Bestimmung von β und M schwieriger und führt gleichzeitig zu größeren Meßfehlern. Daher ist diese Vorgehensweise gegenüber der Verwendung von Hilfsmagnetfeldern 6, die sowohl hinsichtlich Stärke als auch Richtung bekannt sind, nachteilig.

Um den Einfluß von Meßunsicherheiten zu minimieren, wird man möglichst viele oder zumindest mehr als zwei bzw. drei Messungen mit unterschiedlichen Stärken des Hilfsmagnetfeldes 6 durchführen, so daß man eine Vielzahl von Gleichungen (1) mit jeweils unterschiedlichen Meßwerten für H und α erhält, aus denen man dann in bekannter Weise über ein numerisches Anpaß-Verfahren, beispielsweise unter Verwendung eines entsprechenden Computerprogrammes, die in allen diesen Gleichungen jeweils gleichen Werte für M und β bestimmt. Somit erhält man das zu messende Magnetfeld 5 hinsichtlich Stärke und Richtung.

Die numerische Stabilität dieses Anpaß-Verfahrens hängt von der Anzahl der Messungen mit verschiedenen Hilfsmagnetfeldern 6 und von der Größe des Winkels α ab. Je näher α in dem Fall, daß das Hilfsmagnetfeld 6 und das zu messende Magnetfeld 5 senkrecht zueinander orientiert sind, an 45° liegt, desto besser. In diesem Fall ergibt sich der größte Richtungsunterschied zwischen dem zu messenden Magnetfeld 5 und dem aus der Überlagerung resultierenden Magnetfeld 7. Daher ist es günstig, wenn die Richtung des Hilfsmagnetfeldes 6 und die vermutete Richtung des zu messenden Magnetfeldes 5 grob senkrecht zueinander orientiert sind.

Der Meßbereich des erläuterten Meßverfahrens und der zugehörigen Vorrichtung liegt bisher bei ca. 5 mT bis zu ca. 700 mT. Die untere Grenze wird dabei durch den verwendeten GMR- oder AMR-Winkelsensor 12 vorgegeben, der eine gewisse Mindestfeldstärke benötigt, um zumindest weitgehend seine Sättigungsmagnetisierung zu erreichen. Die obere Grenze hat lediglich praktische Gründe, da sich deutlich größere Felder mit der erläuterten Vorrichtung nur schwer erzeugen lassen. Es sei jedoch betont, daß das erläuterte Meßverfahren prinzipiell keinen Beschränkungen hinsichtlich der Stärke des zu messenden Magnetfeldes 5 unterliegt.

Bei Vergleichsmessungen hat sich gezeigt, daß die mit dem erläuterten Meßverfahren ermittelten Stärken und Richtungen von aus der Oberfläche von Magneten austretenden Magnetfeldern 5 in Abständen von ca. 4 mm bis 12 mm zur Oberfläche des Magneten 13 sehr gut mit entsprechenden Messungen mit konventionellen, bei diesen Abständen ebenfalls verwendbaren Hall-Sonden übereinstimmen. Die Meßungenauigkeit liegt dabei bei weniger als 1 mT.

Das erläuterte Ausführungsbeispiel läßt sich, da die konkrete Erzeugung des Hilfsmagnetfeldes 6 nicht von Bedeutung ist und es genügt, wenn dessen Stärke und Richtung am Detektionsort 10 bekannt sind, auch dadurch realisieren, daß der verwendete AMR-Winkelsensor 12 zusätzlich eine Vorrichtung zur Erzeugung des definierten Hilfsmagnetfeldes 6 aufweist oder der AMR-Winkelsensor 12 und eine Vorrichtung zur Erzeugung des Hilfsmagnetfeldes 6 in einem Bauteil integriert sind. In diesem Fall kann auf das Helmholtz-Spulenpaar 11 und das damit erzeugte externe Magnetfeld verzichtet werden. Die genannte Vorrichtung kann beispielsweise eine gemeinsam mit dem AMR-Winkelsensor 12 in einem Bauteil integrierte Spule sein.

Im übrigen eignen sich auch andere Sensoren außer den genannten GMR- oder AMR-Winkelsensoren zur Durchführung des erläuterten Verfahrens, sofern damit zumindest die Richtung des resultierenden Magnetfeldes 7 am Detektionsort 10 meßbar ist.

## Patentansprüche

1. Vorrichtung zur Bestimmung eines Magnetfeldes hinsichtlich dessen Stärke und Richtung an mindestens einem Detektionsort (10), **dadurch gekennzeichnet, daß** ein erstes Mittel vorgesehen ist, das dem Magnetfeld (5) ein zumindest in der Stärke bekanntes Hilfsmagnetfeld (6) überlagert, und daß ein zweites Mittel vorgesehen ist, das zumindest die Richtung des aus der Überlagerung des zu bestimmenden Magnetfeldes (5) und mit Hilfe mindestens zweier, insbesondere nacheinander engelegter Hilfsmagnetfelder (6) resultierenden Magnetfeldes (7) am Detektionsort (10) mißt.

2. Vorrichtung nach Anspruch 1, **dadurch gekennzeichnet, daß** das erste Mittel ein Helmholtz-Spulenpaar (11) ist.

3. Vorrichtung nach Anspruch 1, **dadurch gekennzeichnet, daß** das zweite Mittel ein GMR-Winkelsensor oder ein AMR-Winkelsensor (12) ist.

4. Vorrichtung nach Anspruch 1, **dadurch gekennzeichnet, daß** das erste Mittel und das zweite Mittel in einem Bauteil integriert sind.

5. Vorrichtung nach Anspruch 4, **dadurch gekennzeichnet, daß** ein GMR-Winkelsensor oder ein AMR-Winkelsensor (12) eine Vorrichtung zu Erzeugung des Hilfsmagnetfeldes (6) aufweist.

6. Vorrichtung nach Anspruch 1, **dadurch gekennzeichnet, daß** das zu bestimmende Magnetfeld (5) von einem Magneten (13) hervorgerufen ist und insbesondere aus einer Oberfläche (14) des Magneten (13) austritt.

7. Verfahren zur Bestimmung eines Magnetfeldes hinsichtlich dessen Stärke und Richtung an mindestens einem Detektionsort (10), **dadurch gekennzeichnet, daß** dem Magnetfeld (5) ein zumindest hinsichtlich dessen Stärke bekanntes Hilfsmagnetfeld (6) überlagert wird, und daß dann das von dem zu bestimmenden Magnetfeld (5) und dem Hilfsmagnetfeld (6) erzeugte resultierende Magnetfeld (7) zumindest hinsichtlich dessen Richtung für mindestens zwei unterschiedliche Hilfsmagnetfelder (6) an dem Detektionsort (10) bestimmt wird.

8. Verfahren nach Anspruch 7, **dadurch gekennzeichnet, daß** aus der ermittelten Richtung der resultierenden Magnetfelder (7) das zu bestimmende Magnetfeld (5) errechnet wird.

9. Verfahren nach Anspruch 8, **dadurch gekennzeichnet, daß** das Errechnen des zu bestimmenden Magnetfeldes (5) am Detektionsort (10) mittels einer numerischen Anpassung unter Verwendung der Stärken der Hilfsmagnetfelder (6) sowie der Richtungen der resultierenden Magnetfelder (7) erfolgt.

10. Verfahren nach Anspruch 9, **dadurch gekennzeichnet, daß** zur Verbesserung der numerischen Stabilität der Anpassung eine Vielzahl von Bestimmungen des resultierenden Magnetfeldes (7) mit verschiedenen Hilfsfeldern (6) herangezogen wird.

11. Verfahren nach Anspruch 7, **dadurch gekennzeichnet, daß** das resultierende Magnetfeld (7) und das zu bestimmende Magnetfeld (5) unterschiedliche Richtung haben.

12. Verfahren nach Anspruch 7, **dadurch gekennzeichnet, daß** zur Erzeugung des Hilfsmagnetfeldes (6) ein Helmholtz-Spulenpaar (11) verwendet wird.

13. Verfahren nach Anspruch 7, **dadurch gekennzeichnet, daß** zur Bestimmung der Richtung des resultierenden Magnetfeldes (7) ein AMR-Winkelsensor (12) oder ein GMR-Winkeisensor verwendet wird.

14. Verfahren nach Anspruch 13, **dadurch gekennzeichnet, daß** das Hilfsmagnetfeld (6) über eine in dem GMR-Winkelsensor oder dem AMR-Winkelsensor (12) integrierte Vorrichtung erzeugt wird.

15. Verfahren nach Anspruch 7, **dadurch gekennzeichnet, daß** das Hilfsmagnetfeld (6) derart überlagert wird, daß das zu bestimmende Magnetfeld (5) und das Hilfsmagnetfeld (6) zumindest näherungsweise senkrecht zueinander stehen.

16. Verfahren nach mindestens einem der vorangehenden Ansprüche, **dadurch gekennzeichnet, daß** das zu bestimmende Magnetfeld (5) von einem Magneten (13) hervorgerufen wird.

17. Verwendung des Verfahrens nach mindestens einem der vorangehenden Ansprüche zur Bestimmung eines aus einer Oberflache eines Magneten austretenden Magnetfeldes und insbesondere zur Bestimmung eines weitgehend parallel zur Oberfläche eines Magneten gerichteten Magnetfeldes in unmittelbarer Nähe der Oberfläche des Magneten.

## Claims

1. Device for determining a magnetic field with regard to its strength and direction at at least one detection location (10), **characterized in that** a first means is provided which superimposes on the magnetic field (5) an auxiliary magnetic field (6) of which at least the strength is known, and **in that** a second means is provided which measures, at the detection location (10), at least the direction of the magnetic field (7) resulting from the superposition of the magnetic field (5) to be determined and with the aid of at least two auxiliary magnetic fields (6), particularly applied one after another.

2. Device according to Claim 1, **characterized in that** the first means is a Helmholtz coil pair (11).

3. Device according to Claim 1, **characterized in that** the second means is a GMR angle sensor or an AMR angle sensor (12).

4. Device according to Claim 1, **characterized in that** the first means and the second means are integrated in a component.

5. Device according to Claim 4, **characterized in that** a GMR angle sensor or an AMR angle sensor (12) has a device for producing the auxiliary magnetic field (6).

6. Device according Claim 1, **characterized in that** the magnetic field (5) to be determined is caused by a magnet (13) and, in particular, exits from a surface (14) of the magnet (13).

7. Method for determining a magnetic field with regard to its strength and direction at at least one detection location (10), **characterized in that** the magnetic field (5) has superimposed on it an auxiliary magnetic field (6) of which at least the strength is known, and **in that** then the resulting magnetic field (7) produced by the magnetic field (5) to be determined and the auxiliary magnetic field (6) is determined at least with regard to its direction for at least two different auxiliary magnetic fields (6) at the detection location (10).

8. Method according to Claim 7, **characterized in that** the magnetic field (5) to be determined is calculated from the determined direction of the resulting magnetic fields (7).

9. Method according to Claim 8, **characterized in that** the calculation of the magnetic field (5) to be determined is performed at the detection location (10) by means of a numerical adaptation using the strengths of the auxiliary magnetic fields (6) as well as the directions of the resulting magnetic fields (7).

10. Method according to Claim 9, **characterized in that** a multiplicity of determinations of the resulting magnetic field (7) with the aid of different auxiliary fields (6) is used to improve the numerical stability of the adaptation.

11. Method according to Claim 7, **characterized in that** the resulting magnetic field (7) and the magnetic field (5) to be determined have different directions.

12. Method according Claim 7, **characterized in that** a Helmholtz coil pair (11) is used to produce the auxiliary magnetic field (6).

13. Method according to Claim 7, **characterized in that** an AMR angle sensor (12) or a GMR angle sensor is used to determine the direction of the resulting magnetic field (7).

14. Method according to Claim 13, **characterized in that** the auxiliary magnetic field (6) is produced via a device integrated in the GMR angle sensor or the AMR angle sensor (12).

15. Method according to Claim 7, **characterized in that** the auxiliary magnetic field (6) is superimposed in such a way that the magnetic field (5) to be determined and the auxiliary magnetic field (6) are at least approximately perpendicular to one another.

16. Method according to at least one of the preceding claims, **characterized in that** the magnetic field (5) to be determined is caused by a magnet (13).

17. Use of the method according to at least one of the preceding claims to determine a magnetic field exiting from a surface of a magnet and, in particular, to determine a magnetic field, aligned substantially parallel to the surface of a magnet, in the immediate vicinity of the surface of the magnet.

## Revendications

1. Dispositif pour déterminer l'intensité et la direction d'un champ magnétique à au moins un emplacement de détection (10),
**caractérisé par**
un premier moyen qui combine au champ magnétique (5) un champ magnétique auxiliaire (6) dont on connaît au moins l'intensité, et
un second moyen qui mesure au moins la direction du champ magnétique (7) à l'emplacement de détection (10), ce champ résultant de la combinaison du champ magnétique (5) à déterminer et d'au moins deux champs magnétiques auxiliaires (6) notamment appliqués l'un après l'autre.

2. Dispositif selon la revendication 1,
**caractérisé en ce que**
le premier moyen est une paire de bobines de Helmholtz (11).

3. Dispositif selon la revendication 1,
**caractérisé en ce que**
le second moyen est un capteur d'angle GMR ou un capteur d'angle AMR (12).

4. Dispositif selon la revendication 1,
**caractérisé en ce que**
le premier moyen et le second moyen sont intëgrés dans un composant.

5. Dispositif selon la revendication 4,
**caractérisé en ce qu'**
un capteur d'angle GMR ou un capteur d'angle AMR (12) comporte un dispositif pour générer le champ magnétique auxiliaire (6).

6. Dispositif selon la revendication 1,
**caractérisé en ce que**
le champ magnétique (5) à déterminer sort d'un aimant (13) et en particulier de la surface (14) de cet aimant (13).

7. Procédé pour déterminer l'intensité et la direction d'un champ magnétique en au moins un emplacement de détection (10),
**caractérisé en ce qu'**
on combine au champ magnétique (5), un champ magnétique auxiliaire (6) dont on connaît au moins l'intensité, et le champ magnétique (7) résultant, engendré par le champ magnétique (5) à déterminer et le champ magnétique auxiliaire (6), au moins pour connaître sa direction, est déterminé à l'emplacement de détection (10) avec au moins deux champs magnétiques auxiliaires (6), différents.

8. Procédé selon la revendication 7,
**caractérisé en ce qu'**
on calcule le champ magnétique (5) à déterminer à partir de la direction obtenue pour le champ magnétique résultant.

9. Procédé selon la revendication 8,
**caractérisé en ce qu'**
on calcule le champ magnétique à déterminer (5) à l'emplacement de détection (10) à l'aide d'une adaptation numérique en utilisant les intensités des champs magnétiques auxiliaires (6) ainsi que les directions des champs magnétiques résultants (7).

10. Procédé selon la revendication 9,
**caractérisé en ce que**
pour améliorer la stabilité numérique de l'adaptation, on utilise un grand nombre de déterminations du champ magnétique résultant (7) avec des champs auxiliaires (6) différents.

11. Procédé selon la revendication 7,
**caractérisé en ce que**
le champ magnétique résultant (7) et le champ magnétique à déterminer (5) ont des directions différentes.

12. Procédé selon la revendication 7,
**caractérisé en ce qu'**
on utilise une paire de bobines de Helmholtz (11) pour générer le champ magnétique auxiliaire (6).

13. Procédé selon la revendication 7,
**caractérisé en ce qu'**
on utilise un capteur d'angle AMR (12) ou un capteur d'angle GMR pour déterminer la direction du champ magnétique résultant (7).

14. Procédé selon la revendication 13,
**caractérisé en ce qu'**
on génère le champ magnétique auxiliaire (6) avec un dispositif intégré dans le capteur d'angle GMR ou dans le capteur d'angle AMR (12).

15. Procédé selon la revendication 7,
**caractérisé en ce qu'**
on combine le champ magnétique auxiliaire (6) de façon que le champ magnétique (5) à déterminer et le champ magnétique auxiliaire (6) soient au moins pratiquement perpendiculaires.

16. Procédé selon au moins l'une quelconque des revendications précédentes,
**caractérisé en ce que**
le champ magnétique à déterminer (5) est généré par un aimant (13).

17. Application du procédé selon au moins l'une quelconque des revendications précédentes pour déterminer un champ magnétique sortant de la surface d'un aimant et notamment pour déterminer un champ magnétique pratiquement parallèle à la surface d'un aimant au voisinage immédiat de la surface de cet aimant.
